Europäisches Patentamt

European Patent Office

Office européen des brevets

(19)

(11) **EP 0 690 584 B1**

(12) **FASCICULE DE BREVET EUROPEEN**

(45) Date de publication et mention
de la délivrance du brevet:
**13.11.2002   Bulletin 2002/46**

(51) Int Cl.[7]: **H03M 13/00**

(21) Numéro de dépôt: **95410057.4**

(22) Date de dépôt: **21.06.1995**

(54) **Circuit de localisation d'erreurs d'un décodeur Reed-Solomon**

Schaltung zur Ortung von Fehlern in einem Reed-Solomon Dekoder

Circuit for locating errors in a Reed-Solomon decoder

(84) Etats contractants désignés:
**DE FR GB IT**

(30) Priorité: **27.06.1994   FR 9408122**

(43) Date de publication de la demande:
**03.01.1996   Bulletin 1996/01**

(73) Titulaire: **STMicroelectronics S.A.**
**92120 Montrouge (FR)**

(72) Inventeur: **Meyer, Jacques**
**F-38700 Corenc (FR)**

(74) Mandataire: **de Beaumont, Michel**
**1bis, rue Champollion**
**38000 Grenoble (FR)**

(56) Documents cités:
**EP-A- 0 112 988        EP-A- 0 267 836**

- **GEC JOURNAL OF RESEARCH (INCORPORATING MARCONI.REVIEW.), vol. 9, no. 3, 1992 GREAT BADDOW CHEMSFORD GB, pages 172-184, XP 000304684 ARAMBEPOLA & CHOOMCHUAY 'Algorithms and architectures for Reed-Solomon codes'**
- **PROCEEDINGS OF THE INT. CONF. ON APPLICATION SPECIFIC ARRAY PROCESSORS, 5 Septembre 1990 PRINCETON, NJ, US, XP 000245085 NELSON, RAHMAN & MCQUADE 'Systolic Architectures for decoding Reed-Solomon codes'**
- **IEEE TRANSACTIONS ON COMPUTERS, vol. 37, no. 10, Octobre 1988 NEW YORK US, pages 1273-1280, SHAO & REED 'On the VLSI design of a pipeline Reed-Solomon decoder using systolic arrays'**

**Description**

La présente invention concerne un décodeur Reed-Solomon qui sert à corriger des erreurs subies par des données numériques lors d'une transmission (par voie électrique, hertzienne, ou autre), et plus particulièrement un circuit fournissant les coefficients de deux polynômes caractéristiques nécessaires à corriger ces erreurs.

Un codage Reed-Solomon (RS) consiste à mettre sous forme de codes RS des paquets de données à transmettre, ces données pouvant ensuite être extraites des codes et corrigées au niveau d'un appareil récepteur. Un code RS est un ensemble de M données numériques que l'on associe à des coefficients d'un polynôme de degré M-1 qui est un multiple d'un polynôme générateur de degré 2t ayant 2t racines distinctes. Dans une transmission d'un tel code, on peut localiser et corriger jusqu'à t coefficients erronés.

Les coefficients d'un code RS sont en outre associés à des éléments d'un corps de Galois. Ainsi, si les coefficients à transmettre sont des nombres de n bits, on utilisera un corps de Galois de $2^n$ éléments, noté GF $(2^n)$. Dans ce corps de Galois, un code RS peut comporter jusqu'à $N=2^n-1$ coefficients.

L'addition de deux nombres dans un corps de Galois consiste à effectuer un OU Exclusif bit par bit entre ces deux nombres. D'où il résulte que, si $\alpha$ est un élément quelconque d'un corps de Galois, on a $\alpha+\alpha=0$. La multiplication est définie de manière que le produit de deux éléments du corps de Galois soit également un élément du corps de Galois. Ainsi, tout élément non nul du corps de Galois est une puissance d'un autre élément non nul et non unitaire de ce corps de Galois. Dans un corps de Galois de N+1 éléments, les puissances sont définies modulo N, c'est-à-dire que $\alpha^i=\alpha^{i+N}$, où $\alpha$ est un élément non nul et non unitaire du corps de Galois et i un entier positif ou négatif. Par conséquent, les éléments non nuls d'un corps de Galois de N+1 éléments peuvent être notés $\alpha^0$, $\alpha^1$,... $\alpha^{N-1}$.

Pour transmettre un ensemble de données $a_{N-2t-1}$... $a_0$, selon un codage Reed-Solomon, on forme le polynôme

$$a(x) = a_{N-2t-1}\cdot x^{N-2t-1} + ... + a_1\cdot x + a_0.$$

Ensuite, on transmet les coefficients du polynôme

$$A(x) = x^{2t}\cdot a(x) + r(x),$$

où r(x) est le reste de la division du polynôme $x^{2t}\cdot a(x)$ par le polynôme générateur. Ainsi, les coefficients A du polynôme A(x) constituent un code RS, et ceux correspondant aux termes de degrés 2t à N-1 sont les coefficients $\underline{a}$ que l'on cherche à transmettre. Bien entendu, la transmission est susceptible d'erreurs et certains des coefficients A reçus peuvent être erronés.

La correction d'erreurs s'effectue de la manière suivante. On forme un polynôme syndrome S(x) (ci-après appelé syndrome) de degré 2t-1 dont le coefficient du terme de degré i (i=0, 1,... 2t-1), s'exprime par

$$S_i = A(\alpha^i),$$

où $\alpha^0$, $\alpha^1$,... $\alpha^{2t-1}$ sont les racines du polynôme générateur. S'il n'y a pas eu d'erreurs de transmission, le syndrome est nul, puisque les racines du polynôme générateur sont aussi des racines du polynôme A(x).

Dans le cas contraire, on cherche un polynôme $\lambda(x)$, dit polynôme de localisation d'erreur, de degré inférieur ou égal à t, et un polynôme R(x), dit polynôme de correction d'erreur, de degré inférieur à t, tels que

$$x^{2t}\cdot\gamma(x) + \lambda(x)\cdot S(x) = R(x)$$

où $\gamma(x)$ est un polynôme que l'on ne cherche pas à déterminer.

Le polynôme $\lambda(x)$ a au plus t racines distinctes. Si $\alpha^r$ est une racine du polynôme $\lambda(x)$, le coefficient $A_{N-r}$ a été transmis avec une erreur. L'erreur sur ce coefficient s'exprime par

$$e_r = R(\alpha^r)/\alpha^r\cdot\lambda'(\alpha^r)$$

où $\lambda'$ est le polynôme dérivé du polynôme $\lambda$.

Pour trouver les polynômes $\lambda(x)$ et R(x) on applique l'algorithme d'Euclide. Pour cela, on part du système d'équations suivant :

$$0\cdot x^{2t} + 1\cdot S(x) = S(x)$$

$$1\cdot x^{2t} + 0\cdot S(x) = x^{2t}$$

et, à chacune d'au plus 2t étapes successives, on forme un nouveau système à partir du précédent en remplaçant l'une des équations par une combinaison linéaire des deux équations de manière à supprimer le terme de plus haut degré du second membre et en conservant, parmi les deux équations précédentes, celle dont le second membre est de plus faible degré. On opère ainsi jusqu'à ce que l'on obtienne un second membre de degré inférieur à t. Alors, le second membre est le polynôme R(x) et le polynôme $\lambda(x)$ est celui qui est en facteur de S(x) dans la même équation.

L'article de IEEE Transactions on Computers, Vol. C-34, N° 5, Mai 1985, "A VLSI Design of a Pipeline Reed-Solomon Decoder" décrit un exemple d'application d'algorithme d'Euclide et un circuit pour mettre en oeuvre l'algorithme d'Euclide dans cet exemple. Ce circuit est particulièrement complexe car il nécessite une cellule de calcul relativement complexe par étape de l'algorithme. Chacune des cellules de calcul doit en outre être prévue pour tenir compte de cas particuliers (coefficients de polynôme nuls).

L'article de IEEE transactions on computers, vol. 37, No. 10, Octobre 1988, pages 1273-1280, SHAO & REED "On the VLSI design of a pipeline Reed-Solomon decoder using systolic arrays", a un contenu proche de l'article précédent. Comme dans cet article, chacune des cellules de calcul doit être prévue pour tenir compte de cas particuliers (coefficients de polynômes nuls), ce qui nécessite des moyens particuliers nécessaires à cette fin. Par ailleurs, dans ces documents, le nombre d'itérations à effectuer est variable en fonction des coefficients nuls rencontrés, ce qui nécessite des moyens supplémentaires pour constater la fin des calculs. Ces moyens supplémentaires alourdissent les dispositifs mettant en oeuvre l'algorithme d'Euclide.

Un objet de la présente invention est de prévoir un circuit particulièrement simple pour mettre en oeuvre l'algorithme d'Euclide.

Un autre objet de la présente invention est de prévoir un procédé de commande de ce circuit pour mettre en oeuvre l'algorithme d'Euclide.

Cet objet est atteint grâce à un décodeur Reed-Solomon comprenant des premier et deuxième ensembles de registres dont les contenus sont initialisés respectivement à des valeurs correspondant aux coefficients d'un polynôme syndrome de degré 2t-1 et à des valeurs toutes nulles sauf la deuxième, égale à 1 ; des troisième et quatrième ensembles de registres couplés aux sorties des premier et deuxième ensembles de registres et dont les contenus sont initialisés à des valeurs toutes nulles sauf celui du dernier registre du troisième ensemble, initialisé à 1 par un circuit de calcul associé à chaque registre des premier et deuxième ensembles pour lui fournir la somme du produit du contenu du registre précédent de ces premier et deuxième ensembles par le contenu du dernier registre du troisième ensemble et du produit du contenu du registre correspondant des troisième et quatrième ensembles par le contenu du dernier registre du premier ensemble ; et un compteur et un registre témoin initialisés respectivement à un premier nombre et à un nombre supérieur de 1 au premier nombre, le registre témoin étant couplé à la sortie du compteur. Un séquenceur est prévu pour a) valider en écriture les premier et deuxième ensembles de registres et décrémenter le contenu du compteur si le contenu du compteur est supérieur ou égal au contenu du registre témoin ou si le contenu du dernier registre du premier ensemble est nul, ou b) valider en écriture les premier à quatrième ensembles de registres et le registre témoin si le contenu du compteur est inférieur à celui du registre témoin et que le contenu du dernier registre du premier ensemble est non nul. Le séquenceur arrête la procédure quand le contenu du compteur a diminué de t.

Selon un mode de réalisation de la présente invention, chaque circuit multiplieur comprend des première et deuxième lignes recevant successivement les bits de respectivement les derniers registres des premier et troisième ensembles ; un premier ensemble de portes transmettant la sortie du registre associé des premier et deuxième ensembles si la deuxième ligne est à 1 et un deuxième ensemble de portes transmettant la sortie du registre associé des troisième et quatrième ensembles si la deuxième ligne est à 1 ; un premier additionneur recevant les sorties des premier et deuxième ensembles de portes ; et un deuxième additionneur ajoutant la sortie du premier additionneur au contenu d'un registre de multiplication, le contenu de ce registre étant successivement décalé à gauche et la retenue recombinée à ce contenu de manière à effectuer une multiplication dans un corps de Galois.

Selon un mode de réalisation de la présente invention, le circuit de calcul associé au premier registre du deuxième ensemble effectue son calcul à partir des contenus des derniers registres des deuxième et quatrième ensembles.

Selon un mode de réalisation de la présente invention, le compteur est couplé à la sortie du registre témoin et le séquenceur est prévu pour valider en écriture le compteur et décrémenter celui-ci à chaque étape b).

La présente invention vise également un procédé de détermination de coefficients nécessaires pour corriger jusqu'à t erreurs de transmission de données selon un code Reed-Solomon, comprenant les étapes suivantes :

- déterminer les coefficients d'un polynôme syndrome de degré 2t-1 ;
- stocker les coefficients du polynôme syndrome dans un premier ensemble de registres, des coefficients tous nuls sauf le second, égal à 1, dans un deuxième ensemble de registres, et un premier nombre dans un compteur ;
- stocker des coefficients tous nuls sauf le dernier, égal à 1, dans un troisième ensemble de registres, des coefficients tous nuls dans un quatrième ensemble de registres, et un nombre supérieur de 1 au premier nombre dans un registre témoin ;

  a) si le contenu du compteur est supérieur ou égal à celui du registre témoin ou si le contenu du dernier registre du premier ensemble est nul, stocker dans chaque registre des premier et deuxième ensembles la somme du produit du contenu du registre précédent de ces premier et deuxième ensembles par le contenu du dernier registre du troisième ensemble et du produit du contenu du registre correspondant des troisième et quatrième ensembles par le contenu du dernier registre du premier ensemble, et décrémenter le compteur ;

b) sinon, transférer en outre les contenus des premier et deuxième ensembles de registres et du compteur dans les troisième et quatrième ensembles de registres et le registre témoin ; et

- répéter les étapes a) ou b) jusqu'à ce que le contenu du compteur soit décrémenté de t, et lire alors les coefficients d'un polynôme de correction d'erreur et les coefficients d'un polynôme de localisation d'erreur respectivement dans les premier et deuxième ensembles de registres.

Selon un mode de réalisation de la présente invention, les premier et troisième ensembles comprennent 2t-1 registres, et les deuxième et quatrième ensembles t+1 registres, le premier registre du deuxième ensemble recevant la somme obtenue à partir du contenu du dernier registre de ce deuxième ensemble.

Selon un mode de réalisation de la présente invention, dans l'étape b), les contenus du compteur et du registre témoin sont échangés et le compteur ensuite décrémenté.

Selon un mode de réalisation de la présente invention, le nombre stocké initialement dans le compteur est t.

Selon un mode de réalisation de la présente invention, chaque somme de produits est obtenue selon les étapes suivantes :

- établir successivement des premiers produits partiels des bits du dernier registre du premier ensemble par le contenu d'un registre des troisième et quatrième ensembles ;
- établir successivement des deuxièmes produits partiels des bits du dernier registre du troisième ensemble par le contenu d'un registre des premier et deuxième ensembles ; et
- former successivement les sommes des premiers et deuxièmes produits partiels et les ajouter au contenu d'un registre, décalé à gauche à chaque somme.

Ces objets, caractéristiques, avantages ainsi que d'autres de la présente invention seront exposés plus en détail dans la description suivante de modes de réalisation particuliers faite à titre non limitatif à l'aide des figures jointes parmi lesquelles :

la figure 1 représente une suite d'étapes du procédé selon l'invention dans le cadre d'un exemple ;
la figure 2 représente un mode de réalisation de circuit permettant de mettre en oeuvre le procédé de l'invention ; et
la figure 3 représente partiellement un autre mode de réalisation de circuit permettant de mettre en oeuvre le procédé de l'invention.

Pour mettre en oeuvre l'algorithme d'Euclide, on part bien entendu du système d'équations :

$$0 \cdot x^{2t} + 1 \cdot S(x) = S(x)$$

$$1 \cdot x^{2t} + 0 \cdot S(x) = x^{2t}$$

Selon l'invention, aux premières équations des systèmes successifs obtenus en appliquant l'algorithme d'Euclide, on associe un ensemble de registres R, un ensemble de registres $\lambda$, et un compteur dR. De même, à chaque deuxième équation, est associé un ensemble de registres Q, un ensemble de registres $\mu$, et un registre témoin dQ.

Les registres R, au nombre de 2t notés $R_{2t-1}$, $R_{2t-2}$... $R_0$, correspondent aux coefficients des termes de degrés décroissants du second membre de chaque première équation. Les registres $\lambda$, au nombre de t+1 notés $\lambda_t$ à $\lambda_0$, correspondent aux coefficients des termes de degrés décroissants du facteur de S(x) dans chaque première équation. Le compteur dR contient un nombre représentatif du degré du second membre de chaque première équation.

Similairement, les registres Q sont associés au second membre de chaque deuxième équation, les registres $\mu$ au facteur de S(x) dans chaque deuxième équation, et le registre témoin dQ au degré du second membre de chaque deuxième équation.

Initialement, on stocke, par ordre de degrés décroissants, les coefficients du syndrome dans les registres R, les nombres 0,0,... 0,1,0 dans les registres $\lambda$, les nombres 1,0,...0 dans les registres Q, et des zéros dans les registres $\mu$. Le compteur dR et le registre dQ sont respectivement initialisés à 2t-1 et 2t, par exemple. Ensuite, on opère sur les registres en 2t-1 étapes comprenant chacune l'une des étapes suivantes (dans les expressions, on confond les références des registres avec les contenus des registres).

a) Si le contenu du compteur dR est supérieur ou égal au contenu du registre dQ ou si le contenu du registre $R_{2t-1}$ est nul, le contenu de chaque registre $R_i$ (i = 1, 2... 2t-2) est modifié selon l'expression suivante :

$$R_i = R_{2t-1} \, Q_{i-1} + Q_{2t-1} \, R_{i-1}.$$

Le contenu du registre $R_0$ est annulé à la première étape a).

De même, chaque registre $\lambda_i$ (i = 1, 2... t) est modifié selon l'expression suivante :

$$\lambda_i = R_{2t-1} \, \mu_{i-1} + Q_{2t-1} \, \lambda_{i-1}$$

le contenu du registre $\lambda_0$ étant remplacé par $R_{2t-1} \mu_t + Q_{2t-1} \lambda_t$. Le compteur dR est décrémenté d'une unité.

Dans ce cas, le contenu du registre $\lambda$ est modifié circulairement, c'est-à-dire que le registre $\lambda_0$ reçoit une valeur calculée à partir du contenu du registre $\lambda_t$. Ceci permet de limiter le nombre de registres. On aurait aussi pu prévoir t-1 registres supplémentaires à gauche de chacun des ensembles de registres $\lambda$ et $\mu$.

b) Dans le cas contraire, si le contenu du compteur dR est inférieur à celui du registre dQ et que le contenu du registre $R_{2t-1}$ est non nul, les contenus des registres R et $\lambda$ sont transférés dans les registres Q et $\mu$, et les contenus du compteur dR et du registre dQ sont échangés. En même temps, on effectue aussi les opérations de l'étape a).

Le procédé s'arrête lorsque le compteur dR contient une valeur (t-1 dans ce cas) correspondant à un degré inférieur à t. Alors, les coefficients du polynôme de localisation d'erreur $\lambda(x)$ se trouvent dans les registres $\lambda_t$ à $\lambda_0$ et les coefficients du polynôme de correction d'erreur R(x) se trouvent dans les registres $R_{2t-1}$ à $R_t$.

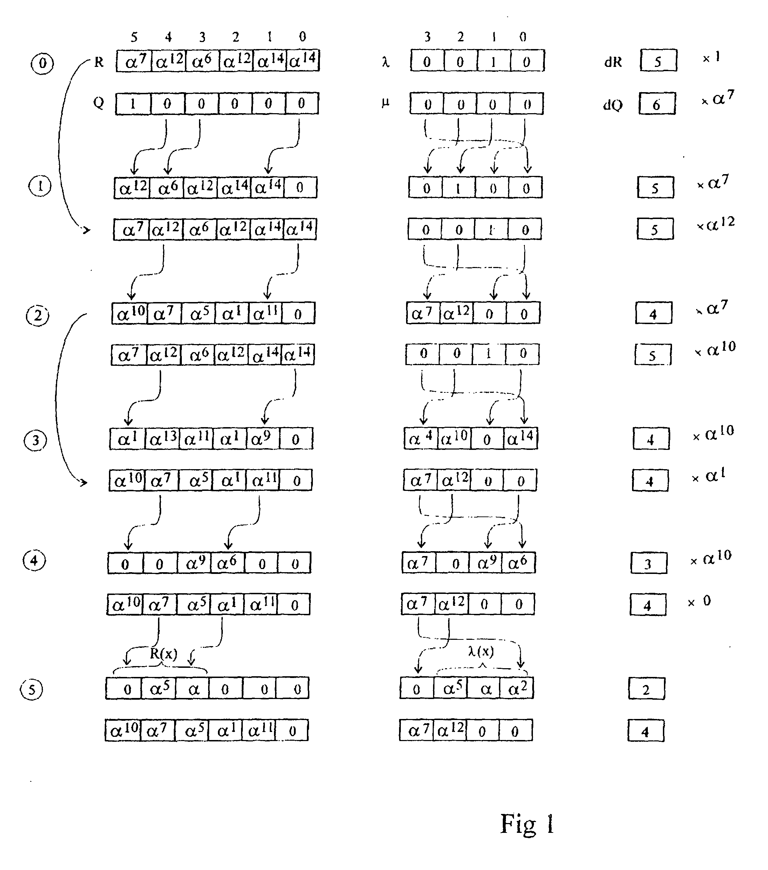

La figure 1 illustre l'application de ce procédé à un exemple de syndrome de degré 5 d'un code Reed-Solomon de coefficients dans un corps de Galois de 15 éléments non nuls $\alpha^0$ à $\alpha^{14}$, avec t=3. Le polynôme syndrome considéré est

$$S(x) = \alpha^7 \cdot x^5 + \alpha^{12} \cdot x^4 + \alpha^6 \cdot x^3 + \alpha^{12} \cdot x^2 + \alpha^{14} \cdot x + \alpha^{14}.$$

Cet exemple est celui utilisé dans l'article de IEEE Transactions On Computers susmentionné. Pour suivre les calculs, on pourra se référer à un tableau de cet article donnant les valeurs binaires des éléments $\alpha^0$ à $\alpha^{14}$.

La figure 1 représente les états des registres R, Q, $\lambda$, $\mu$, et dQ et du compteur dR à des étapes successives, représentées par des nombres entourés, du procédé selon l'invention. Les indices des registres sont représentés au-dessus des registres (0 à 5 pour les registres R et Q, et 0 à 3 pour les registres $\lambda$ et $\mu$).

A une étape initiale 0, les coefficients $\alpha^7$, $\alpha^{12}$, $\alpha^6$, $\alpha^{12}$, $\alpha^{14}$ et $\alpha^{14}$ du syndrome sont stockés dans les registres $R_5$ à $R_0$ respectivement. Les nombres 0,0,1,0 sont stockés dans les registres $\lambda_3$ à $\lambda_0$, les nombres 1, 0, 0, 0, 0, 0 dans les registres $Q_5$ à $Q_0$ et 0,0,0,0 dans les registres $\mu$. Le nombre 5, le degré du syndrome, est stocké dans le compteur dR et le nombre 6 est stocké dans le registre dQ.

Une étape 1 correspond à une étape b) précédemment décrite, puisque le contenu du compteur dR est inférieur à celui du registre dQ et que le contenu du registre $R_5$ est non nul. Les contenus des registres R et $\lambda$ sont multipliés par 1 et les contenus des registres Q

et $\mu$ par $\alpha^7$. Les sommes des produits obtenus sont injectées dans les registres R avec un décalage à gauche simple et dans les registres $\lambda$ avec un décalage à gauche circulaire. En même temps, les anciens contenus des registres R et $\lambda$ sont transférés dans les registres Q et $\mu$. Les contenus du compteur dR et du registre dQ sont échangés, puis le contenu du compteur dQ est décrémenté pour indiquer que le nouveau contenu des registres R correspond à un polynôme de degré 5.

Une étape 2 correspond à une étape a) précédemment décrite, puisque les contenus du compteur dR et du registre dQ sont égaux. Les contenus des registres R et $\lambda$ sont multipliés par $\alpha^7$ et les contenus des registres Q et $\mu$ par $\alpha^{12}$. Les sommes des produits obtenus sont de nouveau injectées dans les registres R avec un décalage à gauche simple et dans les registres $\lambda$ avec un décalage à gauche circulaire. Le compteur dR est décrémenté. Le nouveau contenu des registres R correspond à un polynôme de degré 4.

Des étapes 3 et 4 suivantes correspondent respectivement à une étape b) et une étape a). A l'étape 4, le compteur dR indique que le contenu des registres R correspond à un polynôme de degré 3. Toutefois, ce polynôme est en fait un polynôme de degré 1 car les coefficients des termes de degrés 2 et 3 sont nuls.

Le procédé pourrait s'arrêter en théorie, mais des circuits nécessaires pour exploiter ce cas particulier entraîneraient une complexité supplémentaire inutile. Dans le cas général, on effectue encore une étape car le contenu, 3, du compteur dR n'est pas inférieur à t=3.

Une étape 5 correspond à une étape a) précédemment décrite puisque le contenu du registre $R_5$ est nul. Les contenus des registres R et $\lambda$ multipliés par $\alpha^{10}$ et les contenus des registres Q et $\mu$ par 0. Les sommes sont injectées dans les registres R et $\lambda$ avec un décalage à gauche (circulaire pour les registres $\lambda$). Le contenu du compteur dR est décrémenté. Le procédé s'arrête maintenant car le compteur dR indique un degré inférieur à t=3.

A la fin de l'étape 5, les coefficients contenus dans les registres $R_5$ à $R_3$ sont ceux du polynôme de correction d'erreur R(x), et les coefficients contenus dans les registres $\lambda_3$ à $\lambda_0$ sont ceux du polynôme de localisation d'erreur $\lambda(x)$ (en fait, chacun de ces polynômes est multiplié par une constante, ici $\alpha^{10}$, ce qui n'a aucune influence sur la correction d'erreurs). Dans cet exemple, les polynômes trouvés sont les suivants :

$$R(x) = \alpha^5 \cdot x + \alpha,$$

$$\lambda(x) = \alpha^5 \cdot x^2 + \alpha \cdot x + \alpha^2.$$

Les racines du polynôme $\lambda(x)$ sont $\alpha^{10}$ et $\alpha^3$, ce qui veut dire que, parmi les coefficients reçus, ceux d'indices 15-10 = 5 et 15-3 = 12 sont erronés. Les erreurs correspondantes sont $\alpha^{11}$ et $\alpha^7$.

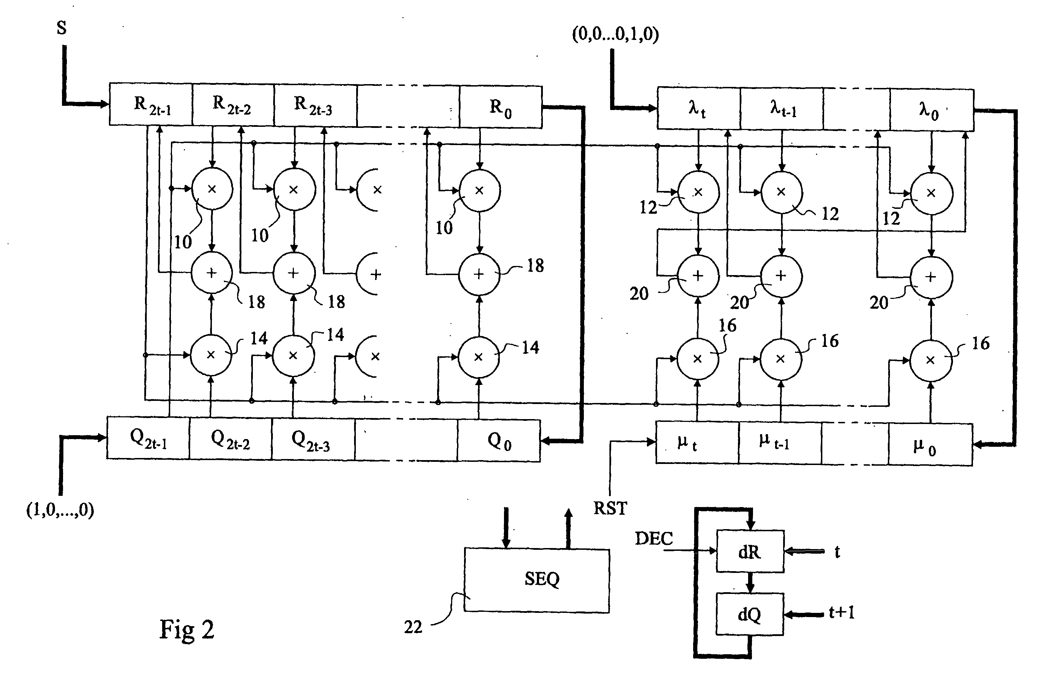

La figure 2 représente un mode de réalisation de circuit permettant de mettre en oeuvre le procédé selon l'invention. Ce circuit est facilement généralisable à des codes Reed-Solomon quelconques. Chacun des registres $R_{2t-2}$ à $R_0$ fournit son contenu à un multiplieur respectif 10, chacun des registres $\lambda_t$ à $\lambda_0$ fournit son contenu à un multiplieur respectif 12, chacun des registres $Q_{2t-2}$ à $Q_0$ fournit son contenu à un multiplieur respectif 14, et chacun des registres $\mu_t$ à $\mu_0$ fournit son contenu à un multiplieur respectif 16. Le contenu du registre $R_{2t-1}$ est fourni à une deuxième entrée des multiplieurs 14 et 16, et le contenu du registre $Q_{2t-1}$ est fourni à une deuxième entrée des multiplieurs 10 et 12. Les sorties des multiplieurs 10 et 14 associés à des registres $R_i$ et $Q_i$ sont fournies à un additionneur respectif 18 dont la sortie est fournie au registre $R_{i+1}$. Les sorties des multiplieurs 12 et 16 associés à des registres $\lambda_i$ et $\mu_i$ sont fournies à un additionneur respectif 20 dont la sortie est fournie au registre $\lambda_{i+1}$, ou $\lambda_0$ si i=t.

Les registres R sont connectés de manière à pouvoir recevoir des valeurs initiales correspondant aux coefficients du syndrome S. Les registres $\lambda$ sont connectés de manière à pouvoir recevoir les valeurs initiales 0,0...0,1,0. Les registres Q sont connectés de manière à pouvoir recevoir les valeurs initiales 1,0,...0. Et les registres $\mu$ ont une entrée RST de mise à 0. Les registres R et $\lambda$ sont reliés respectivement aux registres Q et $\mu$ de manière que les contenus des registres R et $\lambda$ puissent être transférés dans les registres Q et $\mu$. Le compteur dR et le registre dQ sont rebouclés.

Le compteur dR a une entrée de décrémentation DEC et est initialisé à une valeur t. Le registre dQ est initialisé à une valeur t+1. On préfère initialiser le compteur dR à une valeur t, plutôt qu'à une valeur 2t-1 correspondant au degré du syndrome, car il est plus simple de comparer la valeur du compteur dR à 0 qu'à t-1 pour déterminer le moment où il faut t arrêter le procédé.

Un séquenceur 22 compare le contenu du registre $R_{2t-1}$ à 0 et les contenus du compteur dR et du registre dQ entre eux afin d'initialiser l'une des étapes a) ou b) susmentionnées. Le séquenceur 22 commande les registres et le compteur de manière à obtenir les opérations précédemment décrites. La réalisation d'un tel séquenceur est à la portée de l'homme du métier qui pourra, par exemple, retranscrire des étapes de procédé précédemment décrites dans un langage de description de circuit logique, tel que le VHDL.

Les multiplieurs et additionneurs du circuit de la figure 2 sont prévus pour effectuer la multiplication et l'addition définies sur le corps de Galois considéré.

L'addition (OU exclusif) est plus simple que celle des nombres binaires, mais la multiplication est plus complexe.

Si le produit 2nt (n étant le nombre de bits de chaque coefficient) est inférieur au nombre de coefficients des codes Reed-Solomon transmis, on peut utiliser à la place des deux multiplieurs associés à chaque additionneur 18, 20, un seul multiplieur séquentiel qui, en n cycles, établit une multiplication de deux nombres de n bits. Avec des multiplieurs séquentiels, la détermination des polynômes $\lambda$ et R dure 2nt cycles au lieu de seulement 2t cycles. Ceci n'est pas un inconvénient si l'on dispose de 2nt cycles pour traiter chaque code Reed-Solomon car le circuit comportera deux fois moins de multiplieurs séquentiels qui sont en outre plus simples que des multiplieurs non-séquentiels.

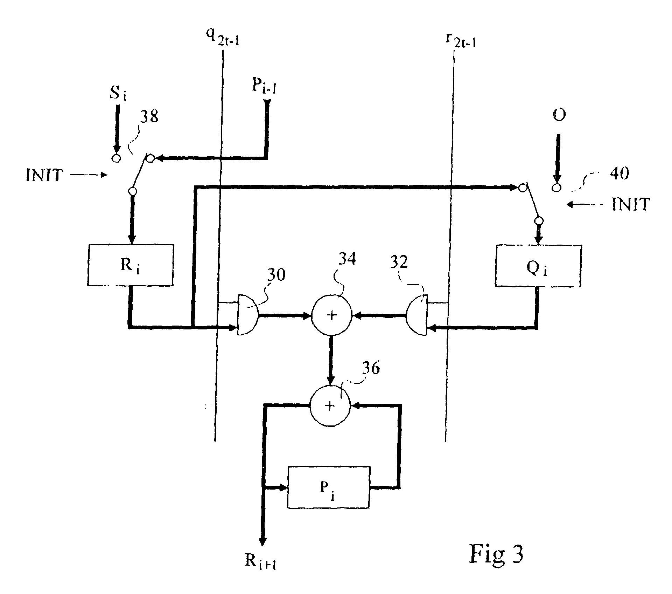

La figure 3 représente un multiplieur séquentiel associé à une paire de registres $R_i$ et $Q_i$ (i≠2t-1). Les sorties des registres $R_i$ et $Q_i$ sont fournies à des ensembles respectifs 30 et 32 de portes ET. L'ensemble de portes 30 est tel qu'il transmet la sortie du registre $R_i$ vers une première entrée d'un additionneur 34 si une ligne $q_{2t-1}$ est à 1. L'ensemble de portes 32 est tel qu'il transmet la sortie du registre $Q_i$ vers une deuxième entrée de l'additionneur 34 si une ligne $r_{2t-1}$ est à 1. Les lignes $q_{2t-1}$ et $r_{2t-1}$ reçoivent successivement les bits de poids décroissants des registres $Q_{2t-1}$ et $R_{2t-1}$ respectivement. La sortie de l'additionneur 34 est ajoutée au contenu d'un registre $P_i$ par un additionneur 36. La sortie de l'additionneur 36 est fournie au registre $R_{i+1}$ de l'étage suivant, et le registre $R_i$ reçoit la sortie de l'additionneur 36 de l'étage précédent.

Les bits successifs du registre $Q_{2t-1}$ sont fournis sur la ligne $q_{2t-1}$ en même temps que les bits successifs du registre $R_{2t-1}$ sont fournis sur la ligne $r_{2t-1}$. Les portes ET 30 et 32 fournissent ainsi successivement des multiplications partielles des contenus des registres $R_i$ et $Q_{2t-1}$ et des contenus des registres $Q_i$ et $R_{2t-1}$. La somme de chaque couple de multiplications partielles, fournie par l'additionneur 34, est ajoutée au contenu du registre Pi, qui est décalé à gauche à chaque somme. Le registre $P_i$ est de la même taille que les registres $R_i$ et $Q_i$ et, lorsqu'il déborde, la retenue est recombinée avec des bits du registre $P_i$ pour obtenir une multiplication dans le corps de Galois considéré. Dans l'exemple du corps de Galois de 16 éléments susmentionné, la retenue est recombinée avec les bits de poids 0 et 1.

Comme cela est représenté, un commutateur 38 est disposé à l'entrée du registre $R_i$. Dans une première position de ce commutateur, le registre $R_i$ reçoit la sortie de l'additionneur 36 de l'étage précédent (si i=0, il reçoit la valeur 0). Dans une deuxième position sélectionnée par la validation d'un signal INIT, le registre $R_i$ reçoit le coefficient Si du syndrome.

Un commutateur 40 est disposé à l'entrée du registre $Q_i$. Dans une première position de ce commutateur 40, le registre $Q_i$ reçoit la sortie du registre $R_i$. Dans une deuxième position du commutateur 40, sélectionnée en validant le signal INIT, le registre $Q_i$ reçoit le nombre 0 (ou 1 si i=2t-1).

Les étages associés aux registres $\lambda$ et $\mu$ sont similaires.

Initialement, le signal INIT est validé. Les registres R, Q, $\lambda$ et $\mu$ reçoivent les valeurs d'initialisation ($S_i$, 0, 1) correspondantes et sont validés pour charger ces valeurs.

Suit une succession d'étapes a) ou b) précédemment décrites. Chacune des étapes comprend n sous-étapes de multiplication partielle au cours desquelles le séquenceur 22 fournit successivement les n bits du registre $R_{2t-1}$ sur la ligne $r_{2t-1}$ et en même temps les n bits du registre $Q_{2t-1}$ sur la ligne $q_{2t-1}$. A chacune de ces sous-étapes, les registres P sont validés de manière à effectuer un décalage à gauche avec recombinaison de retenue.

A la fin de chaque n sous-étapes de multiplication partielle, les additionneurs 36 fournissent les résultats finaux. Chaque registre R et $\lambda$ est alors validé par le séquenceur pour recevoir ces résultats. Dans une étape b), les registres Q et $\mu$ sont validés en même temps que les registre R et $\lambda$ pour recevoir les anciennes valeurs des registres R et $\lambda$.

De nombreuses variantes et modifications de la présente invention apparaîtront à l'homme du métier. Par exemple, au lieu d'échanger les contenus du compteur dR et du registre dQ et ensuite décrémenter le compteur dR, on peut simplement transférer le contenu du compteur dR dans le registre dQ, sans décrémenter le compteur. En outre, pour détecter la fin de la procédure, on peut compter 2t-1 étapes a) ou b) au lieu de surveiller le contenu du compteur dR.

## Revendications

1. Décodeur Reed-Solomon comprenant :

    - des premier et deuxième ensembles de registres (R, $\lambda$) dont les contenus sont initialisés respectivement à des valeurs correspondant aux coefficients d'un polynôme syndrome (S) de degré 2t-1 et à des valeurs toutes nulles sauf la deuxième, égale à 1 ;
    - des troisième et quatrième ensembles de registres (Q, $\mu$) couplés aux sorties des premier et deuxième ensembles de registres et dont les contenus sont initialisés à des valeurs toutes nulles sauf celui du dernier registre du troisième ensemble, initialisé à 1 ;
    - un circuit de calcul (10-18) associé à chaque registre ($R_i$, $\lambda_i$) des premier et deuxième ensembles pour lui fournir la somme du produit du contenu du registre précédent ($R_{i-1}$, $\lambda_{i-1}$) de ces premier et deuxième ensembles par le contenu du dernier registre ($Q_{2t-1}$) du troisième ensemble et du produit du contenu du registre correspondant ($Q_{i-1}$, $\mu_{i-1}$) des troisième et quatrième ensembles par le contenu du dernier registre ($R_{2t-1}$) du premier ensemble ;
    - un compteur (dR) et un registre témoin (dQ) initialisés respectivement à un premier nombre et à un nombre supérieur de 1 au premier nombre, le registre témoin étant couplé à la sortie du compteur ; et
    - un séquenceur (22) pour :

        a) valider en écriture les premier et deuxième ensembles de registres et décrémenter le contenu du compteur (dR) si le contenu du compteur est supérieur ou égal au contenu du registre témoin (dQ) ou si le contenu du dernier registre ($R_{2t-1}$) du premier ensemble est nul ; ou
        b) valider en écriture les premier à quatrième ensembles de registres (R, $\lambda$, Q, $\mu$) et le registre témoin (dQ) si le contenu du compteur (dR) est inférieur à celui du registre témoin et que le contenu du dernier registre du premier ensemble est non nul ; et

        arrêter quand le contenu du compteur a diminué de t.

2. Décodeur Reed-Solomon selon la revendication 1, **caractérisé en ce que** chaque circuit de calcul comprend :

    - des première et deuxième lignes ($r_{2t-1}$, $q_{2t-1}$) recevant successivement les bits de respectivement les derniers registres des premier et troisième ensembles (R, Q) ;
    - un premier ensemble de portes (30) transmettant la sortie du registre associé ($R_i$, $\lambda_i$) des premier et deuxième ensembles si la deuxième ligne est à 1 et un deuxième ensemble de portes (32) transmettant la sortie du registre associé ($Q_i$, $\mu_i$) des troisième et quatrième ensembles si la deuxième ligne est à 1 ;
    - un premier additionneur (34) recevant les sorties des premier et deuxième ensembles de portes (30, 32) ; et
    - un deuxième additionneur (36) ajoutant la sortie du premier additionneur au contenu d'un registre de multiplication ($P_i$), le contenu de ce registre étant successivement décalé à gauche et la retenue recombinée à ce contenu de manière à effectuer une multiplication dans un corps de Galois.

3. Décodeur Reed-Solomon selon la revendication 1, **caractérisé en ce que** le circuit de calcul associé au premier registre du deuxième ensemble ($\lambda$) effectue son calcul à partir des contenus des derniers registres des deuxième et quatrième ensembles.

4. Décodeur Reed-Solomon selon la revendication 1, **caractérisé en ce que** le compteur (dR) est couplé à la sortie du registre témoin (dQ) et **en ce que** le séquenceur (22) est prévu pour valider en écriture le compteur et décrémenter celui-ci à chaque étape b).

**5.** Procédé de détermination de coefficients nécessaires pour corriger jusqu'à t erreurs de transmission de données selon un code Reed-Solomon, comprenant l'étape consistant à

- déterminer les coefficients d'un polynôme syndrome (S) de degré 2t-1,

**caractérisé en ce qu'**il comprend les étapes suivantes :

- stocker les coefficients du polynôme syndrome dans un premier ensemble de registres (R), des coefficients tous nuls sauf le second, égal à 1, dans un deuxième ensemble de registres ($\lambda$), et un premier nombre dans un compteur (dR) ;
- stocker des coefficients tous nuls sauf le dernier, égal à 1, dans un troisième ensemble de registres (Q), des coefficients tous nuls dans un quatrième ensemble de registres ($\mu$), et un nombre supérieur de 1 au premier nombre dans un registre témoin (dQ) ;

a) si le contenu du compteur (dR) est supérieur ou égal à celui du registre témoin (dQ) ou si le contenu du dernier registre ($R_{2t-1}$) du premier ensemble est nul, stocker dans chaque registre des premier et deuxième ensembles (R, $\lambda$) la somme du produit du contenu du registre précédent de ces premier et deuxième ensembles par le contenu du dernier registre ($Q_{2t-1}$) du troisième ensemble et du produit du contenu du registre correspondant des troisième et quatrième ensembles (Q, $\mu$) par le contenu du dernier registre ($R_{2t-1}$) du premier ensemble, et décrémenter le compteur (dR) ;
b) sinon, transférer en outre les contenus des premier et deuxième ensembles de registres (R, $\lambda$) et du compteur (dR) dans les troisième et quatrième ensembles de registres (Q, $\mu$) et le registre témoin (dQ) ; et

- répéter les étapes a) ou b) jusqu'à ce que le contenu du compteur (dR) soit décrémenté de t, et lire alors les coefficients d'un polynôme de correction d'erreur (R) et les coefficients d'un polynôme de localisation d'erreur ($\lambda$) respectivement dans les premier et deuxième ensembles de registres.

**6.** Procédé selon la revendication 5, **caractérisé en ce que** les premier et troisième ensembles (R, Q) comprennent 2t-1 registres, et les deuxième et quatrième ensembles ($\lambda$, $\mu$) t+1 registres, le premier registre ($\lambda_0$) du deuxième ensemble recevant la somme obtenue à partir du contenu du dernier registre ($\lambda_t$) de ce deuxième ensemble.

**7.** Procédé selon la revendication 5, **caractérisé en ce que**, dans l'étape b), les contenus du compteur (dR) et du registre témoin (dQ) sont échangés et le compteur ensuite décrémenté.

**8.** Procédé selon la revendication 5, **caractérisé en ce que** le nombre stocké initialement dans le compteur (dR) est t.

**9.** Procédé selon la revendication 5, **caractérisé en ce que** chaque somme de produits est obtenue selon les étapes suivantes :

- établir successivement des premiers produits partiels des bits du dernier registre ($R_{2t-1}$) du premier ensemble par le contenu d'un registre ($Q_i$, $\mu_i$) des troisième et quatrième ensembles ;
- établir successivement des deuxièmes produits partiels des bits du dernier registre ($Q_{2t-1}$) du troisième ensemble par le contenu d'un registre ($R_i$, $\lambda_i$) des premier et deuxième ensembles ; et
- former successivement les sommes des premiers et deuxièmes produits partiels et les ajouter au contenu d'un registre (P), décalé à gauche à chaque somme.

**Claims**

**1.** A Reed-Solomon decoder including:

- first and second sets of registers (R, $\lambda$) whose contents are respectively initialized at values corresponding to the coefficients of a syndrome polynomial (S) of degree 2t-1 and at values which are all zero except for the second value, equal to 1;
- third and fourth sets of registers (Q, $\mu$) connected to the outputs of the first and second sets of registers and whose contents are initialized at values which are zero except for that of the last register of the third set, which is initialized at 1;
- a calculation circuit (10-18) associated with each register ($R_i$, $\lambda_i$) of the first and second sets to provide said register with the sum of the product of the content of the preceding register ($R_{i-1}$, $\lambda_{i-1}$) of said first and second sets by the content of the last register ($Q_{2t-1}$) of the third set and the product of the content of the corresponding register ($Q_{i-1}$, $\mu_{i-1}$) of the third and fourth sets by the content of the last register ($R_{2t-1}$) of the first set;
- a counter (dR) and an indicator register (dQ) which are respectively initialized at a first number and at a number exceeding the first number by 1, the indicator register being connected to the counter output; and

- a sequencer (22) for:

a) enabling writing of the first and second sets of registers and decrementing the content of the counter (dR) if the content of the counter is higher than or equal to the content of the indicator register (dQ), or if the content of the last register ($R_{2t-1}$) of the first set is zero, or
b) enabling writing of the first, second, third and fourth sets of registers (R, $\lambda$, Q, $\mu$) and the indicator register (dQ) if the content of the counter (dR) is lower than the content of the indicator register and if the content of the last register of the first set is non-zero; and

stopping when the content of the counter is decreased by t.

2. The Reed-Solomon decoder of claim 1, **characterized in that** each calculation circuit includes:

- first and second lines ($r_{2t-1}$, $q_{2t-1}$) successively receiving the bits of the last registers of the first and third sets (R, Q), respectively;
- a first set of gates (30) transmitting the output of the associated register ($R_i$, $\lambda_i$) of the first and second sets if the second line is at 1, and a second set of gates (32) transmitting the output of the associated register ($Q_i$, $\mu_i$) of the third and fourth sets if the second line is at 1;
- a first adder (34) receiving the outputs of the first and second sets of gates (30, 32); and
- a second adder (36) adding the output of the first adder to the content of a multiplication register ($P_i$), the content of the multiplication register being successively shifted to the left and a carry being recombined with this content so that a multiplication in a finite field is carried out.

3. The Reed-Solomon decoder of claim 1, **characterized in that** the calculation circuit associated with the first register of the second set ($\lambda$) executes calculations from the contents of the last registers of the second and fourth sets.

4. The Reed-Solomon decoder of claim 1, **characterized in that** the counter (dR) is connected to the output of the indicator register (dQ) and wherein the sequencer (22) is operable to enable writing of the counter and to decrement the counter at each step b).

5. A method for determining the coefficients required to correct up to t errors in data transmitted as Reed-Solomon codes, including the step of:

- determining the coefficients of a syndrome polynomial (S) of degree 2t-1;

**characterized in that** it includes the steps of:

- storing the coefficients of the syndrome polynomial in a first set of registers (R), storing coefficients which are all zero except for the second, equal to 1, in a second set of registers ($\lambda$), and storing a first number in a counter (dR);
- storing coefficients which are all zero except for the last one, equal to 1, in a third set of registers (Q), storing coefficients which are all zero in a fourth set of registers ($\mu$), and storing a number exceeding the first number by 1 in an indicator register (dQ);

a) if the content of the counter (dR) is higher than or equal to the content of the indicator register (dQ), or if the content of the last register ($R_{2t-1}$) of the first set is zero, storing in each register of the first and second sets (R, $\lambda$) the sum of the product of the content of the preceding register of said first and second sets by the content of the last register ($Q_{2t-1}$) of the third set, and the product of the content of the corresponding register of the third and fourth sets (Q, $\mu$) by the content of the last register ($R_{2t-1}$) of the first set, and decrementing the counter (dR);
b) otherwise, further transferring the contents of the first and second sets of registers (R, $\lambda$) and of the counter (dR) into the third and fourth sets of registers (Q, $\mu$) and the indicator register (dQ); and

- repeating steps a) or b) until the content of the counter (dR) is decremented by t, and then reading the coefficients of an error correction polynomial (R) and the coefficients of an error locator polynomial ($\lambda$), respectively, in the first and second sets of registers.

6. The method of claim 5, **characterized in that** the first and third sets (R, Q) include 2t-1 registers, and the second and fourth sets ($\lambda$, $\mu$) include t+1 registers, the first register ($\lambda_0$) of the second set receiving the sum obtained from the content of the last register ($\lambda_t$) of said second set.

7. The method of claim 5, **characterized in that**, at step b), the contents of the counter (dR) and of the indicator register (dQ) are swapped, and the counter is then decremented.

8. The method of claim 5, **characterized in that** the number initially stored in the counter (dR) is t.

9. The method of claim 5, **characterized in that** each sum of products is obtained according to the following steps:

   - successively establishing first partial products of the bits of the last register ($R_{2t-1}$) of the first set by the content of a register ($Q_i$, $\mu_i$) of the third and fourth sets;
   - successively establishing second partial products of the bits of the last register ($Q_{2t-1}$) of the third set by the content of a register ($R_i$, $\lambda_i$) of the first and second sets; and
   - successively forming the sums of the first and second partial products and adding these sums to the content of a register (P), left-shifted at each addition.

**Patentansprüche**

1. Reed-Solomon-Decoder, welcher umfaßt:

   - erste und zweite Gruppen von Registern (R, $\lambda$), deren Inhalte anfänglich auf Werte entsprechend den Koeffizienten eines Syndrom-Polynoms (S) vom Grad 2t-1 bzw. auf Werte sämtlich gleich Null mit Ausnahme des zweiten Werts mit Betrag gleich 1 initialisiert sind;

   - dritte und vierte Gruppen von Registern (Q, $\mu$), die an die Ausgänge der ersten und zweiten Gruppen von Registern gekoppelt sind und deren Inhalte auf Werte sämtlich gleich Null mit Ausnahme des letzten Registers der dritten Gruppe, das auf 1 initialisiert ist, initialisiert sind;

   - eine jeweils jedem Register ($R_i$, $\lambda_i$) der ersten und der zweiten Gruppe zugeordnete Rechenschaltung (10-18), um dieser die Summe aus dem Produkt des Inhalts des vorhergehenden Registers ($R_{i-1}$, $\lambda_{i-1}$) dieser ersten und zweiten Gruppen mit dem Inhalt des letzten Registers ($Q_{2t-1}$) der dritten Gruppe, und des Produkts aus dem Inhalt des entsprechenden Registers ($Q_{i-1}$, $\mu_{i-1}$) der dritten und vierten Gruppen mit dem Inhalt des letzten Registers ($R_{2t-1}$) der ersten Gruppe zuzuführen;

   - einen Zähler (dR) und ein Indikatorregister (dQ), die auf eine erste Zahl bzw. auf eine die erste Zahl um 1 übersteigende Zahl initialisiert sind, wobei das Indikatorregister mit dem Zählerausgang verbunden ist; sowie

   - eine Sequenzier- bzw. Sortiervorrichtung (22), welche:

     a) die ersten und zweiten Gruppen von Registern in den Schreib-Modus aktiviert und den Inhalt des Zählers (dR) dekrementiert, wenn der Inhalt des Zählers größer als oder gleich dem Inhalt des Indikatorregisters (dQ) ist oder wenn der Inhalt des letzten Registers ($R_{2t-1}$) der ersten Gruppe Null beträgt; oder

     b) die ersten und vierten Gruppen von Registern (R, $\lambda$, Q, $\mu$) und das Indikatorregister (dQ) in den Schreib-Modus aktiviert, wenn der Inhalt des Zählers (dR) kleiner als der des Indikatorregisters ist und wenn der Inhalt des letzten Registers der ersten Gruppe von Null verschieden ist; sowie

   stoppt, sobald der Inhalt des Zählers um t verringert wurde.

2. Reed-Solomon-Decoder nach Anspruch 1, **dadurch gekennzeichnet, daß** jede Rechenschaltung jeweils umfaßt:

   - erste und zweite Leitungen ($r_{2t-1}$, $q_{2t-1}$), die aufeinanderfolgend Bits von den letzten Registern der ersten und dritten Gruppen (R, Q) zugeführt erhalten;

   - eine erste Gruppe von Torschaltungen (30), welche die Ausgangsgröße des den ersten und zweiten Gruppen zugeordneten Registers ($R_i$, $\lambda_i$) übertragen, wenn die zweite Leitung den Wert 1 aufweist, sowie eine zweite Gruppe von Torschaltungen (32), welche die Ausgangsgröße des den dritten und vierten Gruppen zugeordneten Registers ($Q_i$, $\mu_i$) durchlassen, wenn die zweite Leitung sich auf 1 befindet;

   - eine erste Addiervorrichtung (34), welche die Ausgangsgrößen der ersten und zweiten Gruppen von Torschaltungen (30, 32) zugeführt erhält; sowie

   - eine zweite Addiervorrichtung (36), welche die Ausgangsgröße der ersten Addiervorrichtung dem Inhalt eines Multiplikationsregisters ($P_i$) zufügt, wobei der Inhalt dieses Registers aufeinanderfolgend nach links verschoben und der Überlauf mit diesem Inhalt zur Durchführung einer Multiplikation in dem Galois-Körper rekombiniert wird.

**3.** Reed-Solomon-Decoder nach Anspruch 1, **dadurch gekennzeichnet, daß** die dem ersten Register der zweiten Gruppe ($\lambda$) zugeordnete Rechenschaltung ihre Berechnung aufgrund der Inhalte der letzten Register der zweiten und der dritten Gruppe durchführt.

**4.** Reed-Solomon-Decoder nach Anspruch 1, **dadurch gekennzeichnet, daß** der Zähler (dR) mit dem Ausgang des Indikatorregisters (dQ) gekoppelt ist und daß die Sequenzier- bzw. Sortiereinrichtung (22) vorgesehen ist, um den Zähler in den Schreib-Modus zu aktivieren und ihn in jeder Etappe bzw. Stufe b) zu dekrementieren.

**5.** Verfahren zur Bestimmung von Koeffizienten, die erforderlich sind, um bei der Übertragung von Daten gemäß einem Reed-Solomon-Code bis auf t Übertragungsfehler zu korrigieren, wobei das Verfahren eine Verfahrensetappe bzw. -stufe aufweist, welche umfaßt

- Bestimmen der Koeffizienten eines Syndrom-Polynoms (S) vom Grad 2t-1,

**dadurch gekennzeichnet, daß** das Verfahren die folgenden Etappen bzw. Stufen umfaßt:

- Speichern der Koeffizienten des Syndrom-Polynoms in einer ersten Gruppe von Registern (R), Speichern von Koeffizienten, die sämtlich Null sind, ausgenommen den zweiten, der den Betrag 1 besitzt, in einer zweiten Gruppe von Registern ($\lambda$), und Speichern einer ersten Zahl in einem Zähler (dR);

- Speichern der Koeffizienten, die sämtlich Null sind, ausgenommen den letzten, der gleich 1 ist, in einer dritten Gruppe von Registern (Q), Speichern der Koeffizienten, die sämtlich Null sind, in einer vierten Gruppe von Registern ($\mu$), sowie Speichern einer Zahl, die um 1 größer als die erste Zahl ist, in einem Anzeigeregister (dQ); und zwar

    a) wenn der Inhalt des Zählers (dR) größer als oder gleich dem Inhalt des Anzeigeregisters (dQ) ist oder wenn der Inhalt des letzten Registers ($R_{2t-1}$) der ersten Gruppe Null beträgt, Speichern jeweils in jedem Register der ersten und der zweiten Gruppe (R, $\lambda$) der Summe aus dem Produkt des Inhalts des diesen ersten und zweiten Gruppen vorhergehenden Registers mit dem Inhalt des letzten Registers ($Q_{2t-1}$) der dritten Gruppe, und des Produkts des Inhalts des der dritten und vierten Gruppe (Q, $\mu$) entsprechenden Registers mit dem Inhalt des letzten Registers ($R_{2t-1}$) der ersten Gruppe, sowie Dekrementieren des Zählers (dR);

    b) ansonsten weiter Übertragen der Inhalte der ersten und zweiten Gruppe von Registern (R, $\lambda$) und des Zählers (dR) in die dritte und vierte Gruppe von Registern (Q, $\mu$) und das Anzeigeregister (dQ); sowie

- Wiederholen der Verfahrensetappen bzw. -stufen a) oder b), bis der Inhalt des Zählers (dR) um t dekrementiert ist, sowie dann Auslesen der Koeffizienten eines Fehlerkorrektur-Polynoms (R) und der Koeffizienten eines Fehlerlokalisierungs-Polynoms ($\lambda$) in der ersten bzw. der zweiten Gruppe von Registern.

**6.** Verfahren nach Anspruch 5, **dadurch gekennzeichnet, daß** die erste und dritte Gruppe (R, Q) 2t-1 Register umfassen und die zweite und die vierte Gruppe ($\lambda$, $\mu$) t+1 Register umfassen, und daß das erste Register ($\lambda_0$) der zweiten Gruppe die auf der Grundlage des Inhalts des letzten Registers ($\lambda_t$) dieser zweiten Gruppe erhaltene Summe zugeführt erhält.

**7.** Verfahren nach Anspruch 5, **dadurch gekennzeichnet, daß** in der Verfahrensetappe bzw. -stufe b) die Inhalte des Zählers (dR) und des Indikatorregisters (dQ) ausgetauscht werden und der Zähler sodann dekrementiert wird.

**8.** Verfahren nach Anspruch 5, **dadurch gekennzeichnet, daß** die anfänglich in dem Zähler (dR) gespeicherte Zahl t ist.

**9.** Verfahren nach Anspruch 5, **dadurch gekennzeichnet, daß** jeweils jede Produktsumme gemäß den folgenden Verfahrensetappen bzw. -stufen erhalten wird:

- aufeinanderfolgende fortlaufende Feststellung der ersten partiellen Produkte der Bits des letzten Registers ($R_{2t-1}$) der ersten Gruppe mit dem Inhalt eines Registers ($Q_i$, $\mu_i$) der dritten und der vierten Gruppe;

- aufeinanderfolgende fortlaufende Feststellung der zweiten partiellen Produkte der Bits des letzten Registers ($Q_{2t-1}$) der dritten Gruppe mit dem Inhalt eines Registers ($R_i$, $\lambda_i$) der ersten und der zweiten Gruppe; sowie

- aufeinanderfolgende fortlaufende Bildung der Summen der ersten und zweiten Partialprodukte und deren Zufügung zum Inhalt eines Registers (P), das bei jeder Summe nach links ver-

schoben wird.

Fig 1

Fig 2

Fig 3